(19) **Europäisches Patentamt**

**European Patent Office**

**Office européen des brevets**

(11) **EP 1 438 712 B1**

(12) **EUROPEAN PATENT SPECIFICATION**

(45) Date of publication and mention
of the grant of the patent:
**21.12.2005 Bulletin 2005/51**

(21) Application number: **02779477.5**

(22) Date of filing: **11.10.2002**

(51) Int Cl.⁷: **G10L 19/14**

(86) International application number:
**PCT/EP2002/011388**

(87) International publication number:
**WO 2003/036622 (01.05.2003 Gazette 2003/18)**

(54) **METHOD AND APPARATUS FOR DECODING A CODED DIGITAL AUDIO SIGNAL WHICH IS ARRANGED IN FRAMES CONTAINING HEADERS**

VERFAHREN UND VORRICHTUNG ZUM DECODIEREN EINES CODIERTEN DIGITALEN AUDIOSIGNALS, DAS IN KOPFTEILE ENTHALTENDEN RAHMEN ANGEORDNET IST

PROCEDE ET APPAREIL PERMETTANT DE DECODER UN SIGNAL AUDIO NUMERIQUE CODE SITUE DANS DES TRAMES CONTENANT DES EN-TETES

(84) Designated Contracting States:
**DE FR GB IT**

(30) Priority: **23.10.2001 EP 01250372**
**01.03.2002 EP 02090082**

(43) Date of publication of application:
**21.07.2004 Bulletin 2004/30**

(73) Proprietor: **Thomson Licensing**
**92100 Boulogne Billancourt (FR)**

(72) Inventors:
• **SCHRÖDER, Ernst, F.**
**30655 Hannover (DE)**
• **BÖHM, Johannes**
**37083 Göttingen (DE)**

(74) Representative: **Hartnack, Wolfgang**
**Deutsche Thomson-Brandt GmbH**
**European Patent Operations**
**Karl-Wiechert-Allee 74**
**30625 Hannover (DE)**

(56) References cited:
**EP-A- 0 402 973**          **WO-A-00/51243**

**Description**

The invention relates to a method and an apparatus for decoding a coded digital audio signal which is arranged in frames containing headers.

Prior Art

When using audio data reduction on the basis of ISO/IEC standards 11172-3 and 13818-3, a frame length varying by 8 bits is used at a sampling frequency of 44.1 kHz in order to arrive, on average, at a particular fixed data rate (e.g. 128 000 bits/sec). The 'lengthening' of a data frame is signalled by the "padding bit" in the header of a frame. This method is described more accurately in EP-A-0402973. The frames initially also contain a sync word.

Invention

The evaluation of this padding bit in the decoder can cause difficulties. By way of example, in highly optimized decoders, the digital signal processors (DSP) they contain require very sparing use of storage space. Since, however, the header in a frame is read at the start of decoding of the frame, but the value of the padding bit is not needed until right at the end of decoding of this frame, in a DSP implementation an entire storage location (an integer value of, by way of example, several bytes in length) is typically wasted on merely storing the value of the padding bit.
It would be possible to achieve a reduction in the required storage space by dispensing with the 'padding', i.e. the frame lengths would always be kept constant even at a sampling frequency of 44.1 kHz. However, a particular fixed data rate of, by way of example, 128 000 bits/sec is then no longer obtained, but rather a value which is 0.23% lower. A decoder which relies upon a constant frame length always being used even at a sampling frequency of 44.1 kHz would no longer be compatible with the aforementioned ISO/IEC standard, however.

The invention is based on the object of specifying a method which allows less storage space to be used but maintains the compatibility with the ISO/IEC standards 11172-3 and 13818-3 or with similar standards. This object is achieved by the method specified in Claim 1. A decoder using this method is specified in Claim 5.

In accordance with the invention, the data frames of varying length are evaluated on the basis of the respective length, but evaluation of the padding bit from the header is avoided. Since the value of the padding bit is normally used to ascertain the exact position of the start of the next frame, the invention involves ascertaining the start of the next frame in another way, namely by calculating a mean frame length and a rounding-down or rounding-up of this mean frame length to the closest integer byte values for the received frames.

The advantage is that the value of the padding bit does not need to be stored for the entire time taken for decoding a frame, and hence storage space can be saved more frugally.

In principle, the inventive method relates to the decoding of a coded digital audio signal which is arranged in frames containing headers, where the header in a frame contains a respective information item regarding whether this frame has a standard length or a length which differs therefrom for some of the frames, and where the frames contain a respective sync word, having the following steps:

- the length-variation information regarding the respective frame length is not stored or evaluated;
- the approximate start of the next frame is determined using the following formula:

$$L = N * R / fs / SL,$$

where L is equal to the length of the frames, N is equal to the number of samples per frame, R is equal to the total data rate, fs is equal to the sampling frequency, SL is equal to the stipulated subunit for indicating the frame length;

- L is rounded down to the next integer of subunits SL;
- for the subsequent frame, it is first established whether the expected sync word for this frame appears;
- if the expected sync word for this frame appears, this subsequent frame is decoded without taking into account the length-variation information;
- if the expected sync word for this frame does not appear, the decoding of this subsequent frame is started one subunit later without taking into account the length-variation information.

In principle, the inventive apparatus relates to a decoder for decoding a coded digital audio signal which is arranged in frames containing headers, where the header in a frame contains a respective information item regarding whether this frame has a standard length or a length which differs therefrom for some of the frames, and the frames contain a respective sync word, where, for ascertaining the frame length, the length-variation information regarding the respective frame length is not stored or evaluated, and where the apparatus contains:

- means for decoding the audio signal;
- a frame-start estimator in which the approximate start of the next frame is determined using the following formula:

$$L = N * R / fs / SL,$$

$$L = N * R / fs / 8 \qquad (1)$$

where L is equal to the length of the frames, N is equal to the number of samples per frame, R is equal to the total data rate, fs is equal to the sampling frequency, SL is equal to the stipulated subunit, and in which L is rounded down to the next integer of subunits SL;

- a sync-word checker which, for the subsequent frame, first establishes whether the expected sync word for this frame appears, where, if the expected sync word for this frame appears, this subsequent frame is decoded in the decoding means without taking into account the length-variation information, and, if the expected sync word for this frame does not appear, the decoding of this subsequent frame is started in the decoding means one subunit SL later without taking into account the length-variation information.

Instead of evaluating the sync word, another known and expected data pattern can also be evaluated.

Drawings

Exemplary embodiments of the invention are described with reference to the drawings, in which:

Figure 1 shows two successive data frames having the same length;
Figure 2 shows two successive data frames having different lengths;
Figure 3 shows a decoder in accordance with the invention.

Exemplary embodiments

In data-reducing coding and decoding methods for audio signals, such as in ISO/IEC 11172-3 (MPEG audio), the coded audio signals are stored or transmitted in data frames which respectively contain a fixed number N of audio samples, e.g. 1152 samples. The data frames have, in principle, a fixed length which is a multiple of a basic unit, which is called a 'slot' in ISO/IEC 11172-3 and has a length of 8 bits in the 'layer 2' and 'layer 3' variants.

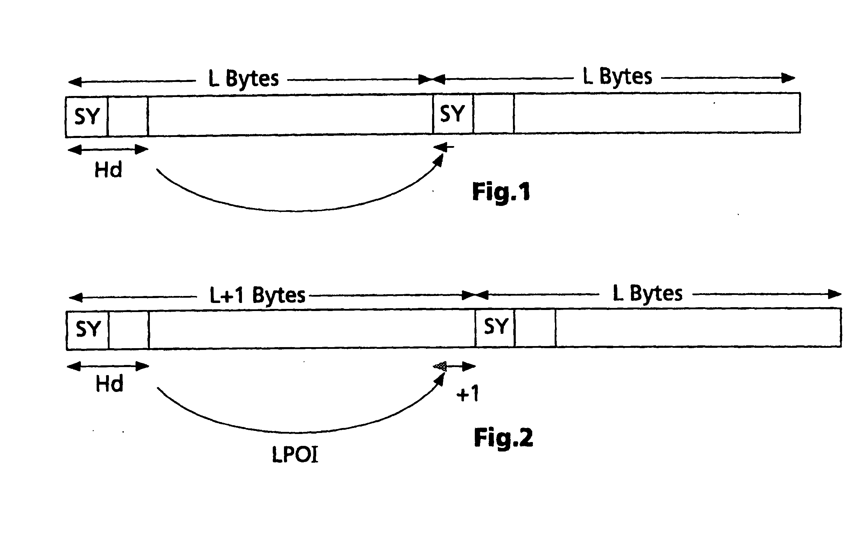

In Figure 1, each of the successive frames of the same length of L bytes has a header Hd which contains a sync word SY. The size of the subunit SL is 1 byte = 8 bits in this example.

If audio signals having sampling frequencies fs of 32 000 Hz or 48 000 Hz are used, then the relationship between the total data rate R (in bits/sec) and the frame length L (in slots) is as follows:

Example:
N = 1152 samples; R = 128 000 bits/sec; fs = 48 000 Hz gives L = 384 slots of 8 bits each.
If, however, a sampling frequency of 44 100 Hz is used, then non-integer values for L are produced in (1). In this way, the start of the next frame is determined only approximately. Example:
N = 1152 samples; R = 128 000 bits/sec; fs = 44 100 Hz gives L = 417.9591837 slots of 8 bits each.
However, since a frame can only have an integer number of slots, a frame length which varies by 1 slot (= 8 bits) is used at a sampling frequency of 44.1 kHz in order to arrive, on average, at a particular fixed data rate (e.g. R = 128 000 bits/sec) and is signalled, as described above, using the padding bit in the header. When the result from formula (1) is rounded down, the correct frame start is often obtained for a sampling frequency of 44.1 kHz, namely for those frames which have not been lengthened by 1 slot. Often, however, an incorrect value is also obtained for the frame start. If the next frame starts to be decoded at this incorrect point, then an error is obtained, since the sync word to be expected at the start of the frame obviously does not appear.
Normally, decoders then switch to an error recovery mode and start a fresh complex search for a sync word. This typically produces a fault in the decoded output signal.
In figure 2, the first frame is one unit SL longer than the second frame, i.e. L+1 bytes. If decoding starts at the place pointed at by the pointer LPOI for the calculated and rounded-down variable L, then no sync word is found at that place. For this reason, a check is carried out one unit SL further on to determine whether a sync word is present, and this sync word is found at that place.
The invention therefore proposes, when decoding encoded signals having the sampling frequency 44 100 Hz or 22 050 Hz:

- not storing or evaluating the padding bit;
- determining the approximate start of the next frame using the formula (1);
- rounding down the result from (1) to the next integer;
- for the subsequent frame, first establishing whether the expected sync word or another known data pattern appears;
- if this is the case, decoding this subsequent frame without taking into account the padding bit;
- if this is not the case, starting the decoding of this subsequent frame one slot later without taking into account the padding bit.

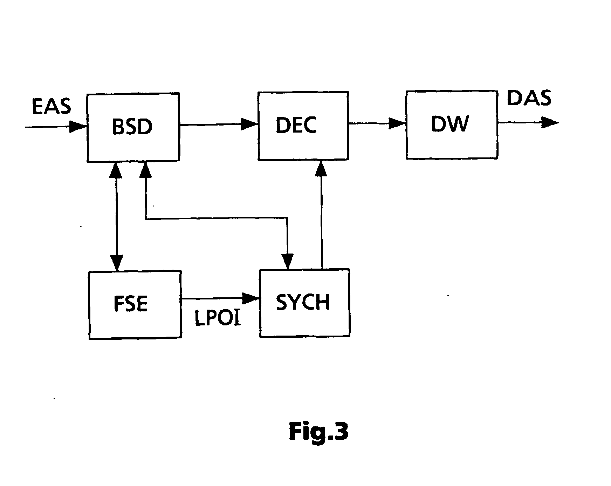

Figure 3 shows an inventive decoder which receives a coded audio signal EAS which is supplied to a bit stream deformatter BSD. BSD interchanges corresponding data with a frame-start estimator FSE. The frame start address estimated therein or a corresponding pointer LPOI is used to establish, in a sync word checker SYCH, whether there is a sync word at the appropriate point in the data stream. If this is so, a decoder stage DEC and/or the bit stream deformatter BSD receives the information which prompts the further processing or decoding of the next data frame to start at that point. The audio signal decoded in the frequency domain is supplied by the decoder stage DEC to a windowing stage DW which multiplies portions of the audio signal using a synthesis filter, for example, converts them to the time domain and outputs a decoded audio signal DAS.

The invention can also be used for related applications in which a non-integer result from (1) causes a variation in the frame length-and said variation is indicated using an information item similar to a 'padding bit'.

**Claims**

1. Method for decoding (BSD, DEC, DW) a coded digital audio signal (EAS) which is arranged in frames containing headers (Hd), where the header in a frame contains a respective information item regarding whether this frame has a standard length (L) or a length (L+1) which differs therefrom for some of the frames, and where the frames contain a respective sync word (SY), **characterized by** the following steps:

   - the length-variation information regarding the respective frame length is not stored or evaluated;
   - the approximate start of the next frame is determined (FSE) using the following formula:

   $$L = N * R / fs / SL,$$

   where L is equal to the length of the frames, N is equal to the number of samples per frame, R is equal to the total data rate, fs is equal to the sampling frequency, SL is equal to the stipulated subunit for indicating the frame length;
   - L is rounded down (FSE) to the next integer of subunits SL;
   - for the subsequent frame, it is first established (SYCH) whether the expected sync word for this frame appears;
   - if the expected sync word for this frame appears, this subsequent frame is decoded (DEC, DW) without taking into account the length-variation information;

   - if the expected sync word for this frame does not appear, the decoding (DEC, DW) of this subsequent frame is started one subunit later without taking into account the length-variation information.

2. Method according to Claim 1, where the parameters for calculating the formula for the approximate frame start comprise known parameters in a transmission system.

3. Method according to Claim 2, where at least one of the parameters is transmitted in the header of frames.

4. Method according to one of Claims 1 to 3, where, instead of establishing whether an expected sync word appears, it is established whether another known pattern appears in the next frame.

5. Apparatus for decoding a coded digital audio signal (EAS) which is arranged in frames containing headers (Hd), where the header in a frame contains a respective information item regarding whether this frame has a standard length (L) or a length (L+1) which differs therefrom for some of the frames, and the frames contain a respective sync word (SY), where, for ascertaining the frame length, the length-variation information regarding the respective frame length is not stored or evaluated, and where the apparatus contains:

   - means (BSD, DEC, DW) for decoding the audio signal (EAS);
   - a frame-start estimator (FSE) in which the approximate start of the next frame is determined using the following formula:

   $$L = N * R / fs / SL,$$

   where L is equal to the length of the frames, N is equal to the number of samples per frame, R is equal to the total data rate, fs is equal to the sampling frequency, SL is equal to the stipulated subunit, and in which L is rounded down to the next integer of subunits SL;
   - a sync-word checker (SYCH) which, for the subsequent frame, first establishes whether the expected sync word for this frame appears, where, if the expected sync word for this frame appears, this subsequent frame is decoded in the decoding means without taking into account the length-variation information, and, if the expected sync word for this frame does not appear, the decoding of this subsequent frame is started in the decoding means one subunit SL later without taking into account the length-variation information.

**Patentansprüche**

1. Verfahren zum Dekodieren (BSD, DEC, DW) eines kodierten digitalen Audiosignals (EAS), das in Rahmen angeordnet ist, die Header (Hd) enthalten, wobei der Header in einem Rahmen ein entsprechendes Informationsmerkmal enthält, ob dieser Rahmen eine normale Länge (L) oder eine Länge (L + 1) hat, die sich davon für einige Rahmen unterscheidet, und wobei die Rahmen ein entsprechendes Synchronisationswort (SY) enthalten, **gekennzeichnet durch** die folgenden Schritte:

   - die Längenänderungs-Information hinsichtlich der entsprechenden Rahmenlänge wird nicht gespeichert oder ausgewertet;
   - der ungefähre Beginn des nächsten Rahmens wird unter Verwendung der folgenden Formel bestimmt (FSE):

   $$L = N * R / fs / SL$$

   worin L gleich der Länge des Rahmens, N gleich der Zahl der Abtastungen pro Rahmen, R gleich der gesamten Datenrate, fs gleich der Abtastfrequenz, SL gleich der geforderten vereinbaren Unter-Einheit zur Anzeige der Rahmenlänge ist;
   - L wird nach unten auf die nächste ganzzahlige Unter-Einheit (SL) abgerundet (FSE);
   - für den folgenden Rahmen wird zunächst festgestellt (SYCH), ob das erwartete Synchronisationswort für diesen Rahmen erscheint;
   - wenn das erwartete Synchronisationswort für diesen Rahmen erscheint, wird dieser nachfolgende Rahmen dekodiert (DEC, DW), ohne die Längenänderungs-Information in Betracht zu ziehen;
   - wenn das erwartete Synchronisationswort für diesen Rahmen nicht erscheint, wird die Dekodierung (DEC, DW) dieses nachfolgenden Rahmens eine Unter-Einheit später begonnen, ohne die Längenänderungs-Information in Betracht zu ziehen.

2. Verfahren nach Anspruch 1, bei dem die Parameter zur Berechnung der Formel für den ungefähren Rahmenbeginn bekannte Parameter in einem Übertragungssystem umfassen.

3. Verfahren nach Anspruch 2, bei dem wenigstens einer der Parameter in dem Header von Rahmen übertragen wird.

4. Verfahren nach einem der Ansprüche 1 bis 3, bei dem anstatt der Feststellung, ob ein erwartetes Synchronisationswort erscheint, festgestellt wird, ob ein anderes bekanntes Schema in dem nächsten Rahmen erscheint.

5. Vorrichtung zum Dekodieren eines kodierten Audiosignals (EAS), das in Rahmen angeordnet ist, die Header (Hd) enthalten, wobei der Header in einem Rahmen ein entsprechendes Informationsmerkmal enthält, ob dieser Rahmen eine Standardlänge (L) oder eine Länge (L + 1) hat, die sich davon für einige der Rahmen unterscheidet, und wobei die Rahmen ein entsprechendes Synchronisationswort (SY) enthalten, und wobei zur Feststellung der Rahmenlänge die Längenänderungs-Information hinsichtlich der entsprechenden Rahmenlänge nicht gespeichert oder bewertet wird, und wobei die Vorrichtung enthält:

   - Mittel (BSD, DEC, DW) zum Dekodieren des Audiosignals (EAS);
   - Einen Rahmenbeginn-Abschätzer (FSE), in dem der ungefähre Beginn des nächsten Rahmens unter Verwendung der folgenden Formel bestimmt wird:

   $$L = N * R / fs / SL,$$

   worin L gleich der Länge der Rahmen, N gleich der Zahl der Abtastungen pro Rahmen, R gleich der Gesamt-Datenrate, fs gleich der Abtastfrequenz, SL gleich der vereinbarten Unter-Einheit ist, und wobei L nach unten auf die nächste ganzzahlige Unter-Einheit SL abgerundet wird;
   - einen Synchronisationswort-Prüfer (SYCH), der für den folgenden Rahmen zunächst feststellt, ob das erwartete Synchronisationswort für diesen Rahmen erscheint, wobei, wenn das erwartete Synchronisationswort erscheint, dieser folgende Rahmen in den Dekodiermitteln dekodiert wird, ohne die Längenänderungs-Information zu berücksichtigen, und wenn das erwartete Synchronisationswort für diesen Rahmen nicht erscheint, die Dekodierung dieses folgenden Rahmens in den Dekodiermitteln eine Unter-Einheit SL später beginnt, ohne die Längenänderungs-Information zu berücksichtigen.

**Revendications**

1. Procédé pour décoder (BSD, DEC, DW) un signal audio numérique codé (EAS) situé dans des trames contenant des en-têtes (Hd), où l'en-tête d'une trame contient un élément d'information respectif indiquant si cette trame possède une longueur standard (L) ou une longueur (L+1) qui diffère de celle-ci pour certaines des trames, et où les trames contiennent un mot synchro respectif (SY), **caractérisé par** les étapes suivantes :

- les informations sur la variation des longueurs concernant la longueur de trame respective ne sont pas stockées ou évaluées ;
- le début approximatif de la trame suivante est déterminé (FSE) à l'aide de la formule suivante :

$$L = N * R / fs / SL,$$

où L est égal à la longueur des trames, N est égal au nombre d'échantillons par trame, R est égal au débit de données total, fs est égal à la fréquence d'échantillonnage, SL est égal à la sous-unité stipulée pour indiquer la longueur de trame ;
- L est arrondi (FSE) au nombre entier inférieur suivant des sous-unités SL ;
- pour la trame suivante, on détermine tout d'abord (SYNCH) si le mot synchro attendu pour cette trame apparaît ;
- si le mot synchro attendu pour cette trame apparaît, cette trame suivante est décodée (DEC, DW) sans tenir compte des informations sur la variation des longueurs ;
- si le mot synchro attendu pour cette trame n'apparaît pas, le décodage (DEC, DW) de cette trame suivante démarre une sous-unité plus tard sans tenir compte des informations sur la variation des longueurs.

2. Procédé selon la revendication 1, où les paramètres pour le calcul de la formule pour le début de trame approximatif comprennent des paramètres connus dans un système de transmission.

3. Procédé selon la revendication 2, où au moins un des paramètres est transmis dans l'en-tête des trames.

4. Procédé selon l'une des revendications 1 à 3, où, au lieu de déterminer si un mot synchro attendu apparaît, on détermine si un autre modèle connu apparaît dans la trame suivante.

5. Appareil pour décoder un signal audio numérique codé (EAS) situé dans des trames contenant des en-têtes (Hd), où l'en-tête d'une trame contient un élément d'information respectif indiquant si cette trame possède une longueur standard (L) ou une longueur (L+1) qui diffère de celle-ci pour certaines des trames, et les trames contiennent un mot synchro respectif (SY), où, pour vérifier la longueur de trame, les informations sur la variation des longueurs concernant la longueur de trame respective ne sont pas stockées ou évaluées, et où l'appareil contient :

- des moyens (BSD, DEC, DW) pour décoder le signal audio (EAS) ;
- un estimateur de début de trame (FSE) dans lequel le début approximatif de la trame suivante est déterminé à l'aide de la formule suivante :

$$L = N * R / fs / SL,$$

où L est égal à la longueur des trames, N est égal au nombre d'échantillons par trame, R est égal au débit de données total, fs est égal à la fréquence d'échantillonnage, SL est égal à la sous-unité stipulée, et dans laquelle L est arrondi au nombre entier inférieur suivant des sous-unités SL ;
- un vérificateur de mot synchro (SYCH) qui, pour la trame suivante, détermine d'abord si le mot synchro attendu pour cette trame apparaît, où, si le mot synchro attendu pour cette trame apparaît, cette trame suivante est décodée dans les moyens de décodage sans tenir compte des informations sur la variation des longueurs, et, si le mot synchro attendu pour cette trame n'apparaît pas, le décodage de cette trame suivante démarre dans les moyens de décodage une sous-unité SL plus tard sans tenir compte des informations sur la variation des longueurs.

EP 1 438 712 B1

**Fig.1**

**Fig.2**

**Fig.3**